# EUROPÄISCHE PATENTSCHRIFT

(11) **EP 3 830 656 B1**
(45) Veröffentlichungstag und Bekanntmachung des Hinweises auf die Patenterteilung: **18.01.2023**
(21) Anmeldenummer: 19748817.4
(22) Anmeldetag: 31.07.2019
(51) Int. Cl.: G05B 19/042, G05B 23/02

(54) **ZWEILEITERFELDGERÄT DER AUTOMATISIERUNGSTECHNIK**
AUTOMATION ENGINEERING TWO-WIRE FIELD DEVICE
APPAREIL DE TERRAIN BIFILAIRE DE LA TECHNIQUE D'AUTOMATISATION

(30) Priorität: 01.08.2018 DE 102018118706
(43) Veröffentlichungstag der Anmeldung: 09.06.2021
(73) Patentinhaber: Endress+Hauser SE+Co. KG, 79689 Maulburg (DE)
(72) Erfinder: SCHMITT, Eric, 68640 Steinsoultz (FR); TRUNZER, Wolfgang, 79540 Lörrach (DE)
(74) Vertreter: Laufer, Michael
(86) Internationale Anmeldenummer: PCT/EP2019/070672
(87) Internationale Veröffentlichungsnummer: WO 2020/025697

(56) Entgegenhaltungen:
- DE-A1- 19 905 071
- DE-A1-102005 047 894
- DE-A1-102011 082 018
- DE-A1-102016 116 378
- US-A1- 2017 093 533

## Beschreibung

Die Erfindung bezieht sich auf ein Zweileiterfeldgerät der Automatisierungstechnik.

In der Automatisierungstechnik, insbesondere in der Prozessautomatisierungstechnik, werden vielfach Feldgeräte eingesetzt, die zur Bestimmung, Optimierung und/oder Beeinflussung von Prozessvariablen dienen. Zur Erfassung von Prozessvariablen dienen Sensoren, wie beispielsweise Füllstandsmessgeräte, Durchflussmessgeräte, Druck- und Temperaturmessgeräte, Leitfähigkeitsmessgeräte, usw., welche die entsprechenden Prozessvariablen Füllstand, Durchfluss, Druck, Temperatur bzw. Leitfähigkeit erfassen. Zur Beeinflussung von Prozessvariablen dienen Aktoren, wie zum Beispiel Ventile oder Pumpen, über die der Durchfluss einer Flüssigkeit in einem Rohrleitungsabschnitt bzw. der Füllstand in einem Behälter geändert werden kann. Als Feldgeräte werden im Prinzip alle Geräte bezeichnet, die prozessnah eingesetzt werden und die prozessrelevante Informationen liefern oder verarbeiten. Im Zusammenhang mit der Erfindung werden unter Feldgeräten also auch Remote I/Os (elektrische Schnittstellen), Funkadapter bzw. allgemein Geräte verstanden, die auf der Feldebene angeordnet sind.

Eine Vielzahl solcher Feldgeräte wird von der Firma Endress + Hauser hergestellt und vertrieben. US2017/0093533 A1 offenbart ein Zweileiterfeldgerät mit einer Diagnoseeinheit.

Gegenwärtig werden in einer Vielzahl der bestehenden Automatisierungsanlagen noch sogenannten Zweileiterfeldgeräte eingesetzt. Diese sind über eine Zweidrahtleitung, d.h. eine Leitung mit zwei separat ausgebildeten Adern, zu einer übergeordneten Einheit, bspw. eine Steuereinheit SPS bzw. Leitsystem, verbunden. Die Zweileiterfeldgeräte sind dabei derartig ausgebildet, dass die Mess- bzw. Stellwerte als Haupt-Prozessvariable über die Zweidrahtleitung bzw. das Zweileiterkabel analog in Form eines 4-20 mA Schleifenstroms bzw. Stromsignals kommuniziert, d.h. übertragen, werden. Hierbei wird ein Schleifenstrom der Zweidrahtleitung entsprechend der erfassten Prozessgröße durch das Feldgerät bzw. die übergeordnete Einheit auf einen spezifischen Wert gestellt.

Zur Übertragung aller anderen Daten hat sich insbesondere das HART Protokoll bewährt, bei dem dem analogen Stromsignal von 4-20 mA ein Frequenzsignal als digitales Zweileitersignal zur Datenübertragung überlagert wird. Gemäß des HART Protokolls wird zwischen 1200 Hz und 2400 Hz zur Datenübertragung umgeschaltet, wobei die niedriger Frequenz für eine logische "0" und die höhere Frequenz für eine logische "1" steht. Auf diese Weise bleibt das sich nur langsam veränderliche analoge Stromsignal von der Frequenzüberlagerung unberührt, so dass mittels HART analoge und digitale Kommunikation vereint wird.

Neben der Datenübertragung dient die Zweidrahtleitung auch zur Versorgung des Zweileiterfeldgerätes. Hierbei wird einer Feldgeräteelektronik, die über eine Anschlussklemme an die Zweidrahtleitung angeschlossen ist, eine zum Betrieb benötigte Leistung in Form einer Klemmenspannung, die über der Anschlussklemme anliegt, und eines Schleifenstroms, der über die Anschlussklemme fließt, zugeführt.

Bei einem geringen Wert des Schleifenstroms, bspw. bei 4 mA, weist die Klemmenspannung in der Regel einen ausreichend hohen Wert für die minimale Klemmenspannung auf, sodass ein fehlerfreier Betrieb des Feldgerätes sichergestellt ist.

Kritischer ist der fehlerfreie Betrieb des Feldgerätes, wenn die Klemmenspannung einen minimalen Wert unterschreitet. Dies kann bspw. dadurch bedingt sein, dass ein Kommunikationswiderstand in die Zweidrahtleitung eingebracht wurde.

Um ein mögliches Unterschreiten der Klemmenspannung rechtzeitig zu erkennen und darauf reagieren zu können, gibt es bereits Ansätze Zweileiterfeldgeräte mit entsprechenden Diagnosemöglichkeiten auszustatten.

Der Erfindung liegt somit die Aufgabe zugrunde, ein Zweileiterfeldgerät der Automatisierungstechnik mit verbesserter Diagnosemöglichkeit vorzuschlagen.

Die Aufgabe wird erfindungsgemäß gelöst durch das Zweileiterfeldgerät der Automatisierungstechnik gemäß Patentanspruch 1.

Das erfindungsgemäße Zweileiterfeldgerät der Automatisierungstechnik umfasst:
- ein Sensorelement zum Erfassen einer Prozessgröße;
- eine Anschlussklemme zum Anschließen einer Zweidrahtleitung;
- eine Feldgeräteelektronik, die Feldgeräteelektronik durch eine Klemmenspannung, die an der Anschlussklemme anliegt, und einen Schleifenstrom, der über die Anschlussklemme fließt, von der Zweidrahtleitung mit einer Betriebsleistung versorgt wird und die dazu eingerichtet ist, in einem Messbetrieb die erfasste Prozessgröße durch Stellen des Schleifenstromes auf einen die Prozessgröße repräsentierenden Wert zwischen 4 mA bis 20 mA über die Zweidrahtleitung zu kommunizieren;
- eine Diagnoseeinheit, die dazu eingerichtet ist, zumindest in dem Messbetrieb bei zumindest zwei verschiedenen Werten des zwischen 4 mA bis 20 mA gestellten Schleifenstroms jeweils zumindest einen entsprechenden Wert für die Klemmenspannung zu erfassen und ausschließlich anhand der im Messbetrieb erfassten Werte eine Aussage über einen minimalen Wert der Klemmenspannung bei einem maximalen Wert des Schleifenstroms, der größer als 21 mA ist, zu treffen.

Der Vorteil eines erfindungsgemäß ausgebildeten Zweileiterfeldgerätes besteht darin, dass zu jedem beliebigen Wert des Schleifenstroms ermittelt werden kann, ob der minimale Wert der Klemmenspannung auch bei einem maximalen Wert des Schleifenstromes ausreichend ist, um die Feldgeräteelektronik entsprechen zu speisen. Darüber hinaus bietet das erfindungsgemäß ausgebildete Zweileiterfeldgerät den Vorteil, dass zur Diagnose nur auf Werte zurückgegriffen wird, die im Messbetrieb erfasst wurden, sodass es keiner "historischer" Daten bedarf, die bspw. in einem separaten Einlern- bzw. Initialisierungsbetrieb erfasst und gespeichert werden müssen.

Eine vorteilhafte Ausgestaltung des Zweileiterfeldgeräts der Automatisierungstechnik sieht vor, dass die Diagnoseeinheit zum Treffen der Aussage anhand der erfassten Werte für die Klemmenspannung und der entsprechenden Werte für den Schleifenstrom den minimalen Wert der Klemmenspannung bei dem maximalen Wert des Schleifenstroms prognostiziert und mit einem minimalen Sollwert für die Klemmenspannung vergleicht. Insbesondere kann die Ausgestaltung vorsehen, dass die Diagnoseeinheit dazu eingerichtet ist, in dem Fall, dass der prognostizierte minimale Wert der Klemmenspannung kleiner als der minimale Sollwert für die Klemmenspannung ist, eine Unterspannung, die nicht zur Leistungsversorgung der Feldgerätelektronik ausreicht, als Aussage zu treffen und/oder dass der minimale Sollwert für die Klemmenspannung im Bereich von 9,5 bis 11,5 V, vorzugsweise im Bereich von 10 bis 11 V liegt, besonders bevorzugt in etwa 10,5 V beträgt.

Eine weitere vorteilhafte Ausgestaltung des Zweileiterfeldgeräts der Automatisierungstechnik sieht vor, dass der maximale Wert des Schleifenstromes im Bereich von 21 - 23 mA liegt.

Eine weitere vorteilhafte Ausgestaltung des Zweileiterfeldgeräts der Automatisierungstechnik sieht vor, dass die Diagnoseeinheit dazu eingerichtet ist, die zumindest zwei verschiedenen Werte des Schleifenstroms und den jeweils zumindest einen entsprechenden Wert für die Klemmenspannung sowie das Treffen der Aussage über den minimalen Wert der Klemmenspannung bei dem maximalen Wert des Schleifenstroms dynamisch durchzuführen. Insbesondere kann die Ausgestaltung vorsehen, dass zur dynamischen Durchführung die Diagnoseeinheit ferner dazu eingerichtet ist, die zumindest zwei verschiedenen Werte des Schleifenstroms und den jeweils zumindest einen entsprechenden Wert für die Klemmenspannung immer dann zu erfassen, wenn im Messbetrieb zwei die erfasste Prozessgröße repräsentierenden Werte des Schleifenstroms einen vorgegebenen Schleifenstromdifferenzwert überschreiten und/oder dass der vorgegebene Schleifenstromdifferenzwert wenigstens 1 mA beträgt.

Eine weitere vorteilhafte Ausgestaltung des Zweileiterfeldgerätes der Automatisierungstechnik sieht vor, dass die Diagnoseeinheit anhand der zumindest zwei verschiedenen Werte des Schleifenstroms und den jeweils zumindest einen entsprechenden Wert für die Klemmenspannung eine lineare Funktion ermittelt und anhand der linearen Funktion den minimalen Wert der Klemmenspannung bei dem maximalen Wert des Schleifenstroms prognostiziert bzw. bestimmt.

Die Erfindung wird anhand der nachfolgenden Zeichnungen näher erläutert. Es zeigt:
Fig. 1: eine schematische Darstellung eines erfindungsgemäßen Zweileiterfeldgerätes der Automatisierungstechnik, und
Fig. 2: ein Spannungs-Strom-Diagramm, in dem die Klemmenspannung gegenüber dem Schleifenstrom dargestellt ist.

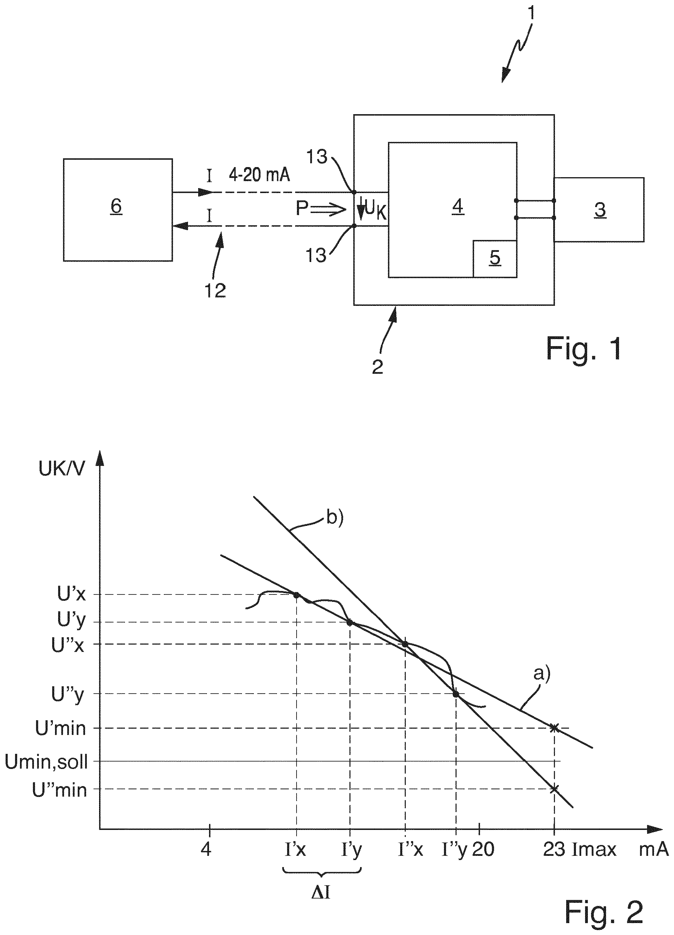

Fig. 1 zeigt eine schematische Darstellung des erfindungsgemäßen Zweileiterfeldgerätes der Automatisierungstechnik 1. Das Feldgerät 1 umfasst ein, vorzugsweise metallisches Gehäuse 2, indem eine Feldgeräteelektronik 4 angeordnet ist, und ein Sensorelement 3 zum Erfassen einer Prozessgröße, bspw. eines Druckmesswerts. Das Zweileiterfeldgerät 1 weist eine Anschlussklemme 13 auf, über die eine Zweidrahtleitung 12 mit den beiden Adern elektrisch an die Feldgeräteelektronik 4 angeschlossen ist bzw. anschließbar ist.

Über die Zweidrahtleitung 12 wird die Feldgeräteelektronik 4 und somit das Feldgerät 1 an eine übergeordnete Einheit, bspw. ein Leitsystem angeschlossen, um mit der übergeordneten Einheit Daten drahtgebunden zu kommunizieren. Hierbei werden die Messwerte als Haupt-Prozessvariable über die Zweidrahtleitung 12 analog in Form eines 4-20 mA Schleifenstroms kommuniziert, indem ein entsprechender Stromwert des 4-20 mA Schleifenstroms durch die Feldgeräteelektronik 4, bspw. einen Stromregler, gestellt wird. In anderen Worten, die Feldgeräteelektronik ist dazu eingerichtet, im Messbetrieb die erfasste Prozessgröße durch Stellen des Schleifenstroms auf einen entsprechenden Wert an die übergeordnete Einheit zu übermitteln.

Andere Daten, die bspw. Parameter des Feldgerätes umfassen können, werden in Form eines digitalen Zweileitersignals, bspw. gemäß dem eingangs erwähnten HART Standard, übertragen.

Ferner wird über die Zweidrahtleitung bzw. den 4-20 mA Schleifenstrom die Feldgeräteelektronik 4 mit Energie versorgt. Hierfür wird, in Abhängigkeit einer Klemmenspannung UK, die an der Anschlussklemme anliegt, und dem 4-20 mA Schleifenstrom, der durch die Anschlussklemme fließt, der Feldgeräteelektronik eine Betriebsleistung zur Verfügung gestellt. Die Klemmenspannung UK umfasst vorzugsweise einen minimalen Spannungswert von ca. 10 V und einen minimalen Wert für den Schleifenstrom von ca. 3,6 mA, sodass sich eine minimale Betriebsleistung für die Feldgeräteelektronik von Lmin = 10V * 3,6 mA = 36 mW ergibt. Die Werte können prinzipiell aber auch davon abweichen, insbesondere kann die Klemmenspannung UK einen minimalen Wert aus dem Bereich von 10-30 V aufweisen.

Um einen sicheren Betrieb des Feldgerätes 1 zu gewähren, ist ferner eine Diagnoseeinheit 5 vorgesehen. Die Diagnoseeinheit 5 kann, wie in Fig. 1 dargestellt, als ein Teil der Feldgeräteelektronik 4 ausgebildet sein oder alternativ als separate Einheit. Vorzugsweise weist die Diagnoseeinheit 5 eine Recheneinheit, bspw. einen Mikroprozessor auf.

Die Diagnoseeinheit 5 ist dazu eingerichtet, eine Spannungsüberwachung der Klemmenspannung UK durchzuführen, umso frühzeitig zu erkennen, ob ein minimaler Sollwert der Klemmenspannung UK bei einem maximalen Wert des Schleifenstroms, der größer als 21 mA und vorzugsweise kleiner 23 mA, besonders bevorzugt ca. 22 mA ist, unterschritten wird. Hierfür werden von der Diagnoseeinheit 5 im Messbetrieb zumindest zwei verschiedene Werte Ix, ly des zwischen 4 bis 20 mA gestellten Schleifenstroms I, sowie der dazu entsprechenden Werte für die Klemmenspannung Ux, Uy erfasst, sodass sich zumindest zwei Wertepaare Ix, Ux und Iy, Uy ergeben. Vorzugsweise erfasst die Diagnoseeinheit 5 die Werte des Schleifenstroms Ix, Iy und die Werte der entsprechenden Klemmenspannung Ux, Uy dynamisch. Dies kann bspw. dadurch erfolgen, dass der Diagnoseeinheit 5 ein Schleifenstromdifferenzwert ΔI vorgegeben wird, und die Diagnoseeinheit 5 die zumindest zwei verschiedenen Werte des Schleifenstroms Ix, Iy immer dann im Messbetrieb erfasst, wenn die zwei verschiedenen Werte des Schleifenstroms Ix, Iy den Schleifenstromdifferenzwert ΔI überschreiten. Dies bedeutet, dass die durch die Diagnoseeinheit 5 erfassten zwei verschiedenen Werte für den Schleifenstrom Ix, Iy und die dazu gehörigen Werte für die Klemmenspannung Ux, Uy sich zumindest um den vorgegeben Differenzwert des Schleifenstroms ΔI unterscheiden. Vorzugsweise kann der Schleifenstromdifferenzwert zumindest 1 mA betragen. Ferner kann der Schleifenstromdifferenzwert ΔI bspw. als ein Parameter durch einen Bediener des Feldgerätes 1 festgelegt werden und in einem Speicher der Feldgeräteelektronik 4 hinterlegt sein. Die Diagnoseeinheit 5 ist ferner dazu eingerichtet, anhand der zwei verschiedenen Werte für den Schleifenstrom Ix, Iy und die dazugehörigen Werte für die Klemmenspannung Ux, Uy eine lineare Funktion zu ermitteln und anhand der linearen Funktion den minimalen Wert der Klemmenspannung Umin, der anliegen würde, wenn der Schleifenstrom I auf einen maximal (möglichen) Wert gestellt würde, zu prognostizieren bzw. zu bestimmen.

Exemplarisch sind in Fig. 2 die zwei Fälle a) und b) dargestellt. Im Fall a) wurde von der Diagnoseeinheit 5 anhand der beiden Wertepaare (I'x, U'x) und (I'y, U'y) eine lineare Funktion ermittelt und anhand der linearen Funktion den minimalen Wert der Klemmenspannung bei einem maximalen bzw. maximal möglichen Wert des Schleifenstroms von 23 mA zu U'min bestimmt. Im Fall b) wurde von der Diagnoseeinheit anhand der beiden Wertepaare I"x, U"x und I"y, U"y eine lineare Funktion ermittelt und anhand der linearen Funktion den minimalen Wert der Klemmenspannung bei einem maximalen bzw. maximal möglichen Wert des Schleifenstroms von 23 mA zu U"min bestimmt.

Die Diagnoseeinheit 5 ist ferner dazu eingerichtet, den prognostizierten bzw. bestimmten minimalen Wert der Klemmenspannung Umin mit einem minimalen Sollwert für die Klemmenspannung Umin,soll zu vergleichen und in dem Fall, dass der minimale Wert der Klemmenspannung Umin den minimalen Sollwert für die Klemmenspannung Umin,soll unterschreitet eine Unterspannung, die möglicherweise nicht zum fehlerfreien Betrieb der Feldgeräteelektronik 4 ausreicht, festzustellen. Die Feststellung der möglichen Unterschreitung der Klemmenspannung UK kann ferner durch die Diagnoseeinheit 5, bspw. in Form einer Fehlermeldung, ausgegeben werden.

### Bezugszeichenliste

- 1: Feldgerät
- 2: Feldgerätegehäuse
- 3: Sensorelement
- 4: Feldgeräteelektronik
- 5: Diagnoseeinheit
- 6: Übergeordnete Einheit
- 12: Zweidrahtleitung bzw. Zweileiter
- 13: Anschlussklemme
- UK: Klemmenspannung
- I: Schleifenstrom
- Ix, Iy: Werte des Schleifenstroms zu bestimmten Zeitpunkten im Messbetrieb des Feldgerätes
- Ux, Uy: Werte der Klemmenspannung bei den zu bestimmten Zeitpunkten im Messbetrieb des Feldgerätes erfassten Werten des Schleifenstroms Ix bzw. Iy
- Umin: Minimaler Wert der Klemmenspannung der anliegen würde, wenn der Schleifenstrom auf einen maximalen Wert gestellt wird
- Umin,soll: Minimal notwendiger Wert der Klemmenspannung der an der Anschlussklemme anliegen muss, damit die Feldgeräteelektronik sicher betrieben werden kann
- Imax: Maximaler Wert auf den der Schleifenstrom, insbesondere im Fehlerfall, gestellt wird
- ΔI: Schleifenstromdifferenzwert

## Patentansprüche

1. Zweileiterfeldgerät der Automatisierungstechnik (1), aufweisend:
- ein Sensorelement (3) zum Erfassen einer Prozessgröße;
- eine Anschlussklemme (13) zum Anschließen einer Zweidrahtleitung (12);
- eine Feldgeräteelektronik (4), die durch eine Klemmenspannung (UK) die an der Anschlussklemme anliegt und einen Schleifenstrom (I) der über die Anschlussklemme fließt von der Zweidrahtleitung mit einer Betriebsleistung versorgt wird und die dazu eingerichtet ist, in einem Messbetrieb die erfasste Prozessgröße durch Stellen des Schleifenstromes auf einen die Prozessgröße repräsentierenden Wert zwischen 4 mA bis 20 mA über die Zweidrahtleitung zu kommunizieren;
**gekennzeichnet durch**:
- eine Diagnoseeinheit (5), die dazu eingerichtet ist, zumindest in dem Messbetrieb bei zumindest zwei verschiedenen Werten des zwischen 4 mA bis 20 mA gestellten Schleifenstroms (Ix, Iy) jeweils zumindest einen entsprechenden Wert für die Klemmenspannung (Ux, Uy) zu erfassen und ausschließlich anhand der im Messbetrieb erfassten Werte (Ix, Iy, Ux, Uy) eine Aussage über einen minimalen Wert der Klemmenspannung (Umin) bei einem maximalen Wert des Schleifenstroms (Imax), der größer als 21 mA ist, zu treffen.

2. Zweileiterfeldgerät der Automatisierungstechnik nach Anspruch 1, wobei die Diagnoseeinheit (5) zum Treffen der Aussage anhand der erfassten Werte für die Klemmenspannung (Ux, Uy) und der entsprechenden Werte für den Schleifenstrom (Ix, Iy) den minimalen Wert der Klemmenspannung (Umin) bei dem maximalen Wert des Schleifenstroms (Imax) prognostiziert und mit einem minimalen Sollwert für die Klemmenspannung (Umin,soll) vergleicht.

3. Zweileiterfeldgerät der Automatisierungstechnik nach dem vorhergehenden Anspruch, wobei die Diagnoseeinheit (5) dazu eingerichtet ist, in dem Fall, dass der prognostizierte minimale Wert der Klemmenspannung (Umin) kleiner als der minimale Sollwert für die Klemmenspannung (Umin,soll) ist, eine Unterspannung, die nicht zur Leistungsversorgung der Feldgerätelektronik (4) ausreicht, als Aussage zu treffen.

4. Zweileiterfeldgerät der Automatisierungstechnik nach dem vorhergehenden Anspruch, wobei der minimale Sollwert für die Klemmenspannung (Umin,soll) im Bereich von 9,5 bis 11,5 V, vorzugsweise im Bereich von 10 bis 11 V liegt, besonders bevorzugt in etwa 10,5 V beträgt.

5. Zweileiterfeldgerät der Automatisierungstechnik nach einem oder mehreren der vorhergehenden Ansprüche, wobei der maximale Wert des Schleifenstromes (Imax) im Bereich von 21 - 23 mA liegt.

6. Zweileiterfeldgerät der Automatisierungstechnik nach einem oder mehreren der vorhergehenden Ansprüche, wobei die Diagnoseeinheit dazu eingerichtet ist, die zumindest zwei verschiedenen Werte des Schleifenstroms (Ix, Iy) und den jeweils zumindest einen entsprechenden Wert für die Klemmenspannung (Ux, Uy) sowie das Treffen der Aussage über den minimalen Wert der Klemmenspannung (Umin) bei dem maximalen Wert des Schleifenstroms (Imax) dynamisch durchzuführen.

7. Zweileiterfeldgerät der Automatisierungstechnik nach dem vorhergehenden Anspruch, wobei zur dynamischen Durchführung die Diagnoseeinheit (5) ferner dazu eingerichtet ist, die zumindest zwei verschiedenen Werte des Schleifenstroms (Ix, Iy) und den jeweils zumindest einen entsprechenden Wert für die Klemmenspannung (Ux, Uy) immer dann zu erfassen, wenn im Messbetrieb zwei die erfasste Prozessgröße repräsentierenden Werte des Schleifenstroms (I) einen vorgegebenen Schleifenstromdifferenzwert (ΔI) überschreiten.

8. Zweileiterfeldgerät der Automatisierungstechnik nach dem vorhergehenden Anspruch, wobei der vorgegebene Schleifenstromdifferenzwert (ΔI) wenigstens 1 mA beträgt.

9. Zweileiterfeldgerät der Automatisierungstechnik nach einem oder mehreren der vorhergehenden Ansprüche, wobei die Diagnoseeinheit anhand der zumindest zwei verschiedenen Werte des Schleifenstroms (Ix, Iy) und den jeweils zumindest einen entsprechenden Wert für die Klemmenspannung (Ux, Uy) eine lineare Funktion ermittelt und anhand der linearen Funktion den minimalen Wert der Klemmenspannung (Umin) bei dem maximalen Wert des Schleifenstroms (Imax) prognostiziert bzw. bestimmt.

## Claims

1. Two-wire field device used in automation engineering (1), wherein said device comprises:
- a sensor element (3) designed to measure a process variable;
- a connection terminal (13) designed to connect a two-wire cable (12);
- a field device electronics unit (4), which is supplied with operating power by a terminal voltage (UK) that is applied to the connection terminal and a loop current (I) which flows from the two-wire cable via the connection terminal, and which is designed to communicate - via the two-wire cable - the recorded process variable in a measuring mode by setting the loop current to a value between 4 mA and 20 mA that represents the process variable;
**characterized in that**:
- a diagnostic unit (5), which is designed to measure - at least in the measuring mode - at least a corresponding value for the terminal voltage (Ux, Uy) at least two different values of the loop current (Ix, ly) that is set between 4 mA and 20 mA, and to issue information about a minimum value of the terminal voltage (Umin) at a maximum value of the loop current (Imax), which is greater than 21 mA, exclusively using the values (Ix, ly, Ux, Uy) measured in the measuring mode.

2. Two-wire field device used in automation engineering as claimed in Claim 1, wherein, for the purpose of issuing the information, the diagnostic unit (5) forecasts the minimum value of the terminal voltage (Umin) at the maximum value of the loop current (Imax) using the values measured for the terminal voltage (Ux, Uy) and the corresponding values for the loop current (Ix, ly), and compares this to a minimum target value for the terminal voltage (Umin,soll).

3. Two-wire field device used in automation engineering as claimed in the previous claim, wherein in the event that the forecast minimum value of the terminal voltage (Umin) is less than the minimum target value for the terminal voltage (Umin,soll), the diagnostic unit (5) is designed to issue information in the form of an undervoltage which does not suffice to provide power to the field device electronics unit (4).

4. Two-wire field device used in automation engineering as claimed in the previous claim, wherein the minimum target value for the terminal voltage (Umin,soll) is in the range from 9.5 to 11.5 V, preferably in the range from 10 to 11 V, particularly preferably is around 10.5 V.

5. Two-wire field device used in automation engineering as claimed in one or more of the previous claims, wherein the maximum value of the loop current (Imax) is in the range from 21 to 23 mA.

6. Two-wire field device used in automation engineering as claimed in one or more of the previous claims, wherein the diagnostic unit is designed to dynamically determine the at least two different values of the loop current (Ix, ly) and the at least one corresponding value, in each case, for the terminal voltage (Ux, Uy), and to issue information about the minimum value of the terminal voltage (Umin) at the maximum value of the loop current (Imax).

7. Two-wire field device used in automation engineering as claimed in the previous claim, wherein, for the purpose of dynamic implementation, the diagnostic unit (5) is further designed to measure the at least two different values of the loop current (Ix, ly) and the at least one corresponding value, in each case, for the terminal voltage (Ux, Uy) each time during the measuring mode when two values of the loop current (I) representing the measured process variable exceed a predefined loop current differential value (ΔI).

8. Two-wire field device used in automation engineering as claimed in the previous claim, wherein the predefined loop current differential value (ΔI) is at least 1 mA.

9. Two-wire field device used in automation engineering as claimed in one or more of the previous claims, wherein the diagnostic unit determines a linear function using the at least two different values of the loop current (Ix, ly) and the at least one corresponding value, in each case, for the terminal voltage (Ux, Uy), and forecasts or determines the minimum value of the terminal voltage (Umin) at the maximum value of the loop current (Imax) using the linear function.

## Revendications

1. Appareil de terrain deux fils de la technique d'automatisation (1), lequel appareil comprend :
- un élément capteur (3) destiné à mesurer une grandeur de process ;
- une borne de raccordement (13) destinée au raccordement d'un câble deux fils (12) ;
- une électronique d'appareil de terrain (4), laquelle électronique est alimentée en puissance de fonctionnement par une tension aux bornes (UK), laquelle tension est appliquée à la borne de raccordement, et par un courant de boucle (I) qui circule à travers la borne de raccordement du câble deux fils, et laquelle électronique est conçue pour communiquer via le câble deux fils, dans un mode de mesure, la grandeur de process mesurée en réglant le courant de boucle à une valeur entre 4 mA et 20 mA représentant la grandeur de process ;
**caractérisé par** :
- une unité de diagnostic (5), laquelle est conçue pour mesurer, au moins dans le mode de mesure, pour au moins deux valeurs différentes du courant de boucle (Ix, ly) réglé entre 4 mA et 20 mA, à chaque fois au moins une valeur correspondante pour la tension aux bornes (Ux, Uy), ainsi que pour émettre, exclusivement à l'aide des valeurs (Ix, Iy, Ux, Uy) mesurées dans le mode de mesure, une information sur une valeur minimale de la tension aux bornes (Umin) pour une valeur maximale du courant de boucle (Imax), qui est supérieure à 21 mA.

2. Appareil de terrain deux fils de la technique d'automatisation selon la revendication 1, pour lequel l'unité de diagnostic (5), pour l'émission de l'information, pronostique la valeur minimale de la tension aux bornes (Umin) pour la valeur maximale du courant de boucle (Imax) à l'aide des valeurs mesurées pour la tension aux bornes (Ux, Uy) et des valeurs correspondantes pour le courant de boucle (Ix, Iy), et la compare à une valeur de consigne minimale pour la tension aux bornes (Umin,soll).

3. Appareil de terrain deux fils de la technique d'automatisation selon la revendication précédente, pour lequel l'unité de diagnostic (5) est conçue pour, dans le cas où la valeur minimale pronostiquée de la tension aux bornes (Umin) est inférieure à la valeur de consigne minimale pour la tension aux bornes (Umin,soll), d'émettre comme information une sous-tension qui ne suffit pas pour l'alimentation en puissance de l'électronique de l'appareil de terrain (4).

4. Appareil de terrain deux fils de la technique d'automatisation selon la revendication précédente, pour lequel la valeur de consigne minimale pour la tension aux bornes (Umin,soll) se situe dans la gamme de 9,5 à 11,5 V, de préférence dans la gamme de 10 à 11 V, particulièrement de préférence est égale à environ 10,5 V.

5. Appareil de terrain deux fils de la technique d'automatisation selon l'une des revendications précédentes, pour lequel la valeur maximale du courant de boucle (Imax) se situe dans la gamme de 21 à 23 mA.

6. Appareil de terrain deux fils de la technique d'automatisation selon l'une ou plusieurs des revendications précédentes, pour lequel l'unité de diagnostic est conçue pour déterminer de manière dynamique les au moins deux valeurs différentes du courant de boucle (Ix, Iy) et la respectivement au moins une valeur correspondante pour la tension aux bornes (Ux, Uy), ainsi que pour émettre une information sur la valeur minimale de la tension aux bornes (Umin) pour la valeur maximale du courant de boucle (Imax).

7. Appareil de terrain deux fils de la technique d'automatisation selon la revendication précédente, pour lequel, pour la mise en œuvre dynamique, l'unité de diagnostic (5) est en outre conçue pour mesurer les au moins deux valeurs différentes du courant de boucle (Ix, ly) et la respectivement au moins une valeur correspondante pour la tension aux bornes (Ux, Uy) à chaque fois que, en mode de mesure, deux valeurs du courant de boucle (I) représentant la grandeur de process mesurée dépassent une valeur de différence de courant de boucle (ΔI) prédéfinie.

8. Appareil de terrain deux fils de la technique d'automatisation selon la revendication précédente, pour lequel la valeur différentielle de courant de boucle (ΔI) prédéfinie est d'au moins 1 mA.

9. Appareil de terrain deux fils de la technique d'automatisation selon l'une ou plusieurs des revendications précédentes, pour lequel l'unité de diagnostic détermine une fonction linéaire à l'aide des au moins deux valeurs différentes du courant de boucle (Ix, Iy) et de la respectivement au moins une valeur correspondante pour la tension aux bornes (Ux, Uy), et pronostique ou détermine à l'aide de la fonction linéaire la valeur minimale de la tension aux bornes (Umin) pour la valeur maximale du courant de boucle (Imax).
